(19) Europäisches Patentamt
European Patent Office
Office européen des brevets

(11) **EP 2 635 911 B1**

(12) **EUROPÄISCHE PATENTSCHRIFT**

(45) Veröffentlichungstag und Bekanntmachung des Hinweises auf die Patenterteilung:
**11.04.2018 Patentblatt 2018/15**

(21) Anmeldenummer: **10776987.9**

(22) Anmeldetag: **05.11.2010**

(51) Int Cl.:
*G01R 31/02* *(2006.01)*     *G01R 31/08* *(2006.01)*
*H02H 3/16* *(2006.01)*     *H02H 3/38* *(2006.01)*

(86) Internationale Anmeldenummer:
**PCT/EP2010/066919**

(87) Internationale Veröffentlichungsnummer:
**WO 2012/059136 (10.05.2012 Gazette 2012/19)**

(54) **ÜBERWACHUNG EINER EINSEITIG GESPEISTEN ENERGIEVERSORGUNGSLEITUNG AUF ERDKURZSCHLÜSSE**

MONITORING A POWER SUPPLY LINE SUPPLIED AT ONE END FOR EARTH FAULTS

SURVEILLANCE D'UNE LIGNE DE DISTRIBUTION D'ÉNERGIE ALIMENTÉE UNILATÉRALEMENT POUR DÉTECTER DES COURTS-CIRCUITS À LA TERRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**11.09.2013 Patentblatt 2013/37**

(73) Patentinhaber: **Siemens Aktiengesellschaft 80333 München (DE)**

(72) Erfinder:
• **BLUMSCHEIN, Jörg**
**14165 Berlin (DE)**
• **DZIENIS, Cezary**
**14624 Dallgow-Döberitz (DE)**
• **KEREIT, Matthias**
**12159 Berlin (DE)**

(56) Entgegenhaltungen:
WO-A1-2010/006632     WO-A1-2010/037711
CH-A- 304 849     DE-A1- 4 026 799
DE-A1- 4 439 499     DE-C- 881 821
DE-C- 956 609

• **"3.1.6 Anregung (Fehlererkennung)" In: Gerhard Ziegler: "Digitaler Distanzschutz", 1. März 2008 (2008-03-01), Publics Corporate Publishing, Nürnberg, XP002659290, ISBN: 978-3-89578-320-3 Bd. 2, Seiten 29-39, das ganze Dokument -& "A2 Rechnen mit symmetrischen Komponenten, Grundlagen" In: Gerhard Ziegler: "Digitaler Distanzschutz", 1. März 2008 (2008-03-01), Publics Corporate Publishing, Nürnberg, XP002659984, ISBN: 978-3-89578-320-3 Bd. 2, Seiten 363-369, das ganze Dokument**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zum Überwachen einer einseitig gespeisten Energieversorgungsleitung eines dreiphasigen elektrischen Energieversorgungsnetzes im Hinblick auf das Vorliegen eines Erdkurzschlusses, wobei die Energieversorgungsleitung an ihrem der Einspeisung abgewandten Ende mit einem in Stern-Dreieckschaltung betriebenen Transformator verbunden ist. Die Erfindung bezieht sich auch auf ein elektrisches Schutzgerät, mit dem eine entsprechende Überwachung durchgeführt werden kann.

Solche einseitig gespeisten elektrischen Energieversorgungsleitungen, also Energieversorgungsleitungen, die lediglich an einem Ende mit einer elektrischen Energiequelle verbunden sind, die elektrische Energie in die Leitung einspeist, und die mit ihrem anderen Ende mit einem in Stern-Dreieckschaltung betriebenen Transformator verbunden sind, stellen in elektrischen Energieversorgungsnetzen keine Seltenheit dar. Solche Netzkonfigurationen treten beispielsweise bei sogenannten Stichleitungen oder in radialen Netzen auf.

Elektrische Schutzgeräte werden eingesetzt, um die Energieversorgungsleitung und daran angeschlossene weitere Primärkomponenten (z.B. den Transformator) vor hohen Belastungen aufgrund von Kurzschlüssen zu schützen. Dazu nehmen solche Schutzgeräte üblicherweise Messwerte, die Strom und Spannung an einer Messstelle der Energieversorgungsleitung repräsentieren, auf und untersuchen diese unter Anwendung sogenannter Schutzalgorithmen auf Zustände, die auf einen Kurzschluss auf der Energieversorgungsleitung hindeuten.

Bei der beschriebenen Konfiguration mit einer einseitig gespeisten Energieversorgungsleitung, die an ihrem anderen Ende mit einem in Stern-Dreieckschaltung betriebenen Transformator betrieben ist, kann beim Auftreten eines ein- oder zweipoligen Erdkurzschlusses ein Effekt beobachtet werden, der in der Fachliteratur als "Bauchsches Paradoxon" bezeichnet wird.

Hierbei wirkt sich ein ein- oder zweipoliger Erdkurzschluss über die magnetische Kopplung des Transformators auch auf die eigentlich "gesunden", also nicht von dem Erdkurzschluss betroffenen Phasenleiter der Energieversorgungsleitung aus, so dass die Gefahr besteht, dass ein elektrisches Schutzgerät aufgrund der an einer Messstelle aufgenommenen Ströme und Spannungen Fehlentscheidungen trifft und eine ungewollte Abschaltung von funktionstüchtigen Phasenleitern vornimmt.

Ein Verfahren und ein Schutzgerät der eingangs genannten Art sind beispielsweise aus der DE 881 821 bekannt.

Häufig werden zur Überwachung von elektrischen Energieversorgungsleitungen elektrische Schutzgeräte eingesetzt, die nach dem Distanzschutzprinzip arbeiten. Dabei wird anhand von Impedanzen der einzelnen Leiter-Leiter-Schleifen und Leiter-Erde-Schleifen auf das Vorhandensein von Kurzschlüssen und Erdkurzschlüssen geschlossen. Im Falle des Bauchschen Paradoxons sind insbesondere die Bestimmung der fehlerbehafteten Schleife und der Richtung, in der der Erdkurzschluss vom Schutzgerät aus gesehen liegt, beeinträchtigt, da z.B. bei einem zweipoligen Erdkurzschluss sich die Impedanz in der Phase-Phase-Schleife nicht mehr messtechnisch erfassen lässt, weil die Differenz der Ströme in den fehlerbehafteten Phasen Null beträgt. Außerdem kann es vorkommen, dass der Richtungsmessungsalgorithmus für eine Phase-Erde-Schleife eine Vorwärtsrichtung erkennt, während für die andere Phase-Erde-Schleife hingegen eine Rückwärtsrichtung ermittelt wird. Auch bei einpoligen Erdkurzschlüssen können bei Verwendung der üblichen Richtungsmessungsalgorithmen falsche Richtungsentscheidungen ausgegeben werden. Zudem werden häufig alle drei Phasenleiter abgeschaltet, obwohl der Erdkurzschluss sich nur auf einen Phasenleiter bezieht.

Üblicherweise wird zur Lösung dieses Problems ein weiteres Schutzgerät, das eine Überwachung der Energieversorgungsleitung nach der Methode des Überstromschutzes bzw. Überstrom-Zeitschutzes ("UMZ-Charakteristik" bzw. "AMZ-Charakteristik") durchführt, als Reserveschutz vorgesehen. Der Erdfehlerschutz eines derart arbeitenden Reserveschutzgerätes hat den Nachteil, dass er wesentlich langsamer ist als ein Distanzschutzalgorithmus. Außerdem handelt der Überstromzeitschutz zum einen nicht immer phasenselektiv und zum anderen überhaupt nicht leitungsselektiv.

Der vorliegenden Erfindung liegt daher die Aufgabe zugrunde, ein Verfahren zum Überwachen einer Energieversorgungsleitung der eingangs angegebenen Art sowie ein entsprechendes Schutzgerät anzugeben, womit eine zuverlässige und selektive Abschaltung eines Erdkurzschlusses auch beim Auftreten des Kopplungseffektes gemäß dem Bauchschen Paradoxon stattfinden kann.

Zur Lösung dieser Aufgabe wird erfindungsgemäß ein Verfahren der eingangs genannten Art derart ausgebildet, bei dem an einer Messstelle, die an dem der Einspeisung abgewandten Ende der Energieversorgungsleitung liegt, die Phasenströme in den einzelnen Phasenleitern der Energieversorgungsleitung sowie der Nullsystemstrom ermittelt werden, ein Erdkurzschlussverdachtssignal erzeugt wird, wenn die einzelnen Phasenströme und der Nullsystemstrom im Wesentlichen gleich groß und in Phase sind, und das Erdkurzschlussverdachtssignal bei der weiteren Überwachung im Hinblick auf das Vorliegen des Erdkurzschlusses herangezogen wird, wobei zur Erkennung der Richtung, in der der Erdkurzschluss in Bezug auf die Messstelle liegt, der negative Nullsystemstromzeiger und der dazugehörende Nullsystemspannungszeiger verglichen werden und ein einen Erdkurzschluss in Vorwärtsrichtung angebendes Vorwärtssignal erzeugt wird, wenn der Nullsystemspannungszeiger dem negativen Nullsystemstromzeiger um einen Phasenwinkel mit einem vorgegebenen Differenzwert nacheilt.

Dieser Lösung liegt die Erkenntnis zugrunde, dass bei dem Bauchschen Paradoxon die Kopplung der Fehlerwirkung über den Transformator im Wesentlichen auf eine starke Nullsystemkomponente zurückzuführen ist, die auf der Sekundärseite des Transformators einen zirkulierenden Stromfluss erzeugt, der sich gleichmäßig auf alle drei Phasenleiter der Primärseite zurückkoppelt. Zur Untersuchung, ob der Effekt des Bauchschen Paradoxons im aktuellen Fehlerfall vorliegt, wird daher erfindungsgemäß die Untersuchung der Phasenleiterströme und des Nullsystemstroms an der Messstelle, die sich auf der Primärseite des Transformators befindet, daraufhin vorgeschlagen, ob die Phasenleiterströme und der Nullsystemstrom im Wesentlichen - das heißt, unter Vernachlässigung messtechnisch bedingter Abweichungen - gleich groß sind und eine übereinstimmende Phasenlage aufweisen. Eine positive Erkennung des Vorliegens des Effektes gemäß dem Bauchschen Paradoxon wird in Form des Erdkurzschlussverdachtssignals gemeldet, das entsprechend bei der weiteren Spezifizierung des Fehlers herangezogen wird.

Außerdem lässt sich prüfen, ob der Erdkurzschluss vom Schutzgerät aus gesehen auf der überwachten Energieversorgungsleitung (in Vorwärtsrichtung) oder außerhalb der Energieversorgungsleitung (in Rückwärtsrichtung) liegt. Da auch zweipolige Erdkurzschlüsse gemeinsam anhand des Nullsystemstromes und der Nullsystemspannung beurteilt werden, wird eine uneinheitliche Entscheidung über die Fehlerrichtung verhindert.

Um eine leichte Möglichkeit zur numerischen Erkennung des Vorliegens des Bauchschen Paradoxons in einem Schutzgerät anzugeben, wird gemäß einer vorteilhaften Ausführungsform des erfindungsgemäßen Verfahrens konkret vorgeschlagen, dass zur Überprüfung der Phasenlage der Phasenströme und des Nullsystemstroms auch der Mitsystemstrom und der Gegensystemstrom an der Messstelle ermittelt werden und der Nullsystemstrom einerseits mit dem Mitsystemstrom und andererseits mit dem Gegensystemstrom verglichen wird und ein erstes Indikatorsignal gebildet wird, wenn der Nullsystemstrom sowohl den Mitsystemstrom als auch den Gegensystemstrom um einen vorgegebenen Faktor übersteigt. Außerdem wird der Nullsystemstrom auch mit den einzelnen Phasenströmen verglichen und es wird ein zweites Indikatorsignal gebildet, wenn der Nullsystemstrom und die einzelnen Phasenströme nahezu gleich groß sind, und es wird das Erdkurzschlussverdachtssignal erzeugt, wenn sowohl das erste Indikatorsignal als auch das zweite Indikatorsignal vorliegen.

Diese Ausführungsform besitzt den Vorteil, dass auf eine aufwendige Untersuchung der Phasenlage der einzelnen Phasenströme und des Nullsystemstroms verzichtet werden kann, da die übereinstimmende Phasenlage hierbei durch den Vergleich der Nullsystem-, Gegensystem- und Mitsystemkomponenten des Stroms an der Messstelle überprüft werden kann. Hinsichtlich der Untersuchung der Größe der einzelnen Phasenströme und des Nullsystemstromes kann dann eine Betrachtung auf Amplitudenbasis der einzelnen Ströme erfolgen, wodurch der Algorithmus deutlich vereinfacht wird.

Eine weitere vorteilhafte Ausführungsform des erfindungsgemäßen Verfahrens sieht vor, dass bei vorliegendem Erdkurzschlussverdachtssignal zur Ermittlung der von dem Erdkurzschluss betroffenen Phasenleiter ein Vergleich der Zeiger für die Mitsystemspannung an der Messstelle und die Gegensystemspannung an der Messstelle durchgeführt wird, und ein auf einen zweipoligen Erdkurzschluss hindeutendes erstes Fehlerartsignal gebildet wird, wenn der von diesen Zeigern eingeschlossene Phasenwinkel etwa 0°, 120° oder 240° beträgt, und andernfalls ein zweites Fehlerartsignal gebildet wird, das auf einen einpoligen Erdkurzschluss hinweist.

Auf diese Weise lässt sich sehr zuverlässig die Fehlerart des Erdkurzschlusses bestimmen, das heißt, ob es sich um einen einpoligen Fehler oder einen zweipoligen Fehler handelt. Mit dieser Information kann eine nachfolgende Erkennung der von dem Erdkurzschluss betroffenen Fehlerschleife deutlich erleichtert werden.

Da durch messtechnische Abweichungen die ideale Phasendifferenz von 0°, 120° oder 240° nie exakt auftreten wird, wird vorgeschlagen, dass auch dann das erste Fehlerartsignal gebildet wird, wenn der von den Zeigern für die Mitsystemspannung und die Gegensystemspannung eingeschlossene Phasenwinkel um einen Ansprechschwellenwert von 0°, 120° oder 240° abweicht, wobei der Ansprechschwellenwert dynamisch von der Höhe der Mitsystemspannung und der Gegensystemspannung abhängt. Gemäß einer weiteren vorteilhaften Ausführungsform kann zur Erkennung der konkret von dem Erdkurzschluss betroffenen Fehlerschleife vorgesehen sein, dass bei vorliegendem ersten Fehlerartsignal die verketteten Phasenspannungen der einzelnen Phasenleiter miteinander verglichen werden und ein erstes Schleifenselektionssignal gebildet wird, das diejenigen Phasenleiter, die gemeinsam die niedrigste verkettete Phasenspannung bilden, als von einem zweipoligen Erdkurzschluss betroffen angibt, und bei vorliegendem zweiten Fehlerartsignal die Phase-Erde-Spannungen der einzelnen Phasenleiter verglichen werden und ein zweites Schleifenselektionssignal gebildet wird, das denjenigen Phasenleiter, der die niedrigste Phase-Erde-Spannung aufweist, als von einem einpoligen Erdkurzschluss betroffen angibt.

Hierdurch kann aufgrund vergleichsweise einfach abprüfbarer Bedingungen bezogen auf die verketteten Phasenspannungen - also die zwischen den einzelnen Phasenleitern jeweils bestehenden Leiter-Leiter-Spannungen - bzw. auf die jeweiligen Phase-Erde-Spannungen eine Erkennung der betroffenen Fehlerschleife durchgeführt werden.

Eine weitere vorteilhafte Ausführungsform des erfindungsgemäßen Verfahrens sieht zudem vor, dass bei vorliegendem Vorwärtssignal ein Fehlersignal erzeugt wird, dass ein Abschalten des von dem Erdkurzschluss jeweils betroffenen Phasenleiters bewirkt.

Auf diese Weise kann insbesondere bei einpoligen Kurzschlüssen selektiv jeweils nur der tatsächlich von dem Fehler betroffenen Phasenleiter abgeschaltet werden, die gesunden Phasenleiter bleiben hingegen eingeschaltet.

Gemäß einer weiteren vorteilhaften Ausführungsform des erfindungsgemäßen Verfahrens ist vorgesehen, dass für eine von dem Erdkurzschluss betroffene Phasenleiter-Erde-Schleife ein Impedanzzeiger bestimmt wird und die Lage des Impedanzzeigers in einem vorgegebenen Anregegebiet in der komplexen Zahlenebene untersucht wird, ein Bestätigungssignal erzeugt wird, wenn der Impedanzzeiger in dem Anregegebiet liegt, und das Fehlersignal zum Abschalten des von dem Erdkurzschluss betroffenen Phasenleiters nur dann erzeugt wird, wenn auch das Bestätigungssignal vorliegt.

Auf diese Weise kann zusätzlich noch eine Impedanzbasierte Prüfung der fehlerbehafteten Schleife durchgeführt werden, um die Sicherheit der Fehlererkennung noch weiter zu erhöhen.

Eine weitere vorteilhafte Ausführungsform des erfindungsgemäßen Verfahrens sieht zudem vor, dass das Verfahren von einem Distanzschutzgerät ausgeführt wird, das eine Überwachung der Energieversorgungsleitung unter Anwendung eines Fehlererkennungsalgorithmus nach Art eines Distanzschutzes durchführt, und bei Vorliegen des Erdkurzschlussverdachtssignals üblicherweise im Rahmen des von dem Distanzschutzgerät ausgeführten Fehlererkennungsalgorithmus durchgeführte Erkennungsalgorithmen zur Erkennung einer fehlerbehafteten Schleife und einer Fehlerrichtung blockiert werden.

Auf diese Weise kann das erfindungsgemäße Verfahren vorteilhaft in einem Distanzschutzgerät implementiert werden, das üblicherweise ohnehin zur Ermittlung der benötigten Messgrößen eingerichtet ist. Um das im Falle des Vorliegens des Bauchschen Paradoxons unzuverlässige Verhalten der Fehlererkennung nach dem herkömmlichen Distanzschutzprinzip zu verbessern, werden bei positiver Erkennung des Bauchschen Paradoxons, also bei vorliegendem Erdkurzschlussverdachtssignal, die im Rahmen des Distanzschutzes üblicherweise durchgeführten Algorithmen zur Schleifenauswahl und zur Richtungserkennung blockiert und durch entsprechend angepasste Algorithmen wie voranstehend beschrieben ersetzt.

Hinsichtlich des Schutzgerätes wird die oben genannte Aufgabe durch ein elektrisches Schutzgerät zur Überwachung einer einseitig gespeisten Energieversorgungsleitung eines dreiphasigen elektrischen Energieversorgungsnetzes im Hinblick auf das Vorliegen eines Erdkurzschlusses gelöst, wobei die Energieversorgungsleitung an ihrem der Einspeisung abgewandten Ende mit einem in Stern-Dreieckschaltung betriebenen Transformator verbunden ist. Das Schutzgerät weist eine Messeinrichtung zur Erfassung von Phasenströmen und Phasenspannungen an einer Messstelle, die an dem der Einspeisung abgewandten Ende der Energieversorgungsleitung liegt, und eine Datenverarbeitungseinrichtung, die zur Verarbeitung der Phasenströme und Phasenspannungen eingerichtet ist, auf.

Erfindungsgemäß ist vorgesehen, dass die Datenverarbeitungseinrichtung zur Durchführung eines Verfahrens gemäß einer der voranstehenden Ausführungsformen eingerichtet ist.

Die Erfindung soll im Folgenden anhand von Ausführungsbeispielen näher erläutert werden. Hierzu zeigen

Figur 1    eine schematische Ansicht einer einseitig gespeisten Energieversorgungsleitung;

Figur 2    eine Darstellung der Stromflussrichtungen in den Phasenleitern der Energieversorgungsleitung bei einem einpoligen Erdkurzschluss;

Figur 3    eine Darstellung der Stromflussrichtungen in den Phasenleitern der Energieversorgungsleitung bei einem zweipoligen Erdkurzschluss;

Figur 4    eine Darstellung des einpoligen Erdkurzschlusses auf der Energieversorgungsleitung in symmetrischen Komponenten;

Figur 5    eine Darstellung des zweipoligen Erdkurzschlusses auf der Energieversorgungsleitung in symmetrischen Komponenten;

Figur 6    ein schematisches Ablaufdiagramm eines Verfahrens zur Erkennung eines Erdkurzschlusses in der Energieversorgungsleitung; und

Figur 7    ein Kennfeld zur Beurteilung der Fehlerrichtung eines Erdkurzschlusses.

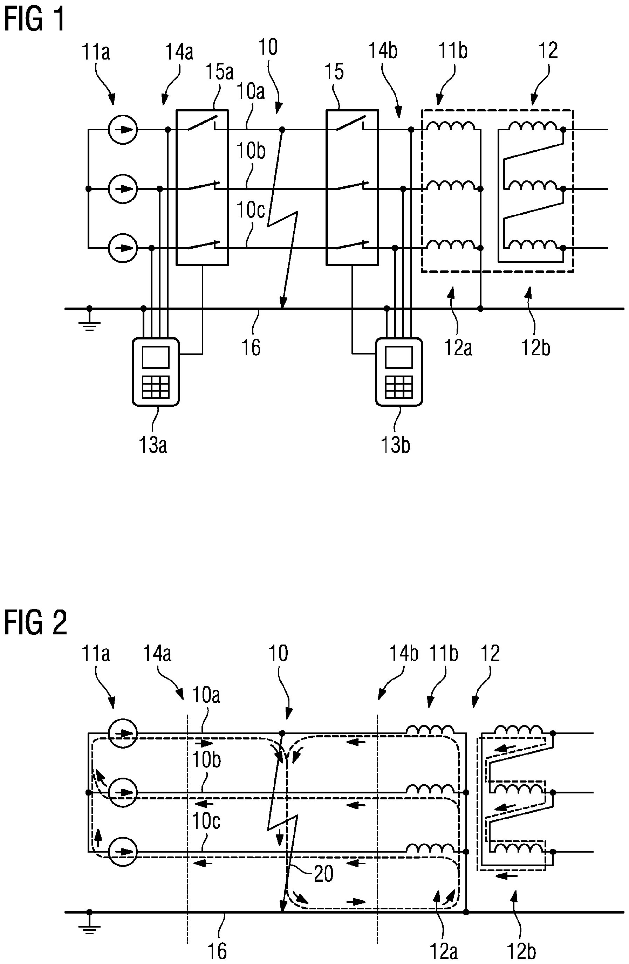

In den Figuren 1 bis 7 stehen identische Bezugszeichen für einander entsprechende Komponenten.

Figur 1 zeigt in schematischer Ansicht eine dreiphasige elektrische Energieversorgungsleitung 10 eines ansonsten nicht näher dargestellten elektrischen Energieversorgungsnetzes. Die Energieversorgungsleitung 10 weist Phasenleiter 10a, 10b, 10c auf und wird von ihrem einen Ende 11a her von einer nur schematisch angedeuteten elektrischen Energiequelle gespeist. Mit ihrem anderen Ende 11b, also dem der Einspeisung abgewandten Ende, ist die Energieversorgungsleitung 10 mit einem Transformator 12 verbunden, der in einer Stern-Dreieck-Betriebsform verschaltet ist.

Das bedeutet, dass auf der Primärseite 12a des Transformators die Wicklungen der drei Phasenleiter 10a-c in einem gemeinsamen geerdeten Sternpunkt zusammengeführt sind. Auf der Sekundärseite 12b des Transformators sind die einzelnen Wicklungen zwischen jeweils zwei Phasenleiter geschaltet.

Die Energieversorgungsleitung 10 wird mittels Schutzgeräten 13a und 13b, bei denen es sich beispielsweise um Distanzschutzgeräte handeln kann, auf Fehler überwacht, insbesondere findet eine Überprüfung statt, ob ein oder mehrere Phasenleiter 10a-c der Energieversorgungsleitung 10 einen Kurzschluss mit Erdberührung, also einen Erdkurzschluss, aufweisen. Dazu nimmt das Schutzgerät 13a an einer an dem einen Ende 11a der Leitung liegenden Messstelle 14a über lediglich schematisch angedeutete Strom- und Spannungswandler Messwerte bezüglich der Phasenströme und Phasenspannungen auf, führt eine Analog-Digital-Wandlung und ggf. weitere Signalvorverarbeitungen durch und wertet die Messwerte dann unter Verwendung sogenannter Schutzalgorithmen aus. In entsprechender Weise nimmt das Schutzgerät 13b an einer an dem der Einspeisung abgewandten anderen Ende 11b der Leitung liegenden Messstelle 14b Messwerte bezüglich der Phasenströme und Phasenspannungen auf, führt eine Analog-Digital-Wandlung und ggf. weitere Signalvorverarbeitungen durch und wertet die Messwerte dann unter Verwendung der Schutzalgorithmen aus.

Wird während der Auswertung der Messwerte von den Schutzgeräten 13a bzw. 13b ein Fehler, insbesondere ein Erdkurzschluss, auf der Energieversorgungsleitung 10 identifiziert, so wird ein Fehlersignal an einen entsprechenden Leistungsschalter 15a, 15b abgegeben, der durch Öffnen der entsprechenden Schaltkontakte den fehlerbehafteten Phasenleiter, im Beispiel der Figur 1 den Phasenleiter 10a, ausschaltet.

Bei der in der Figur 1 dargestellten Konfiguration einer einseitig gespeisten Energieversorgungsleitung 10 mit einem angeschlossenen in Stern-Dreieck-Schaltung betriebenen Transformator 12 kann es im Falle von einpoligen (Phasenleiter - Erde) oder zweipoligen (Phasenleiter - Phasenleiter - Erde) Kurzschlüssen mit Verbindung mit Erde 16 zum Auftreten des Bauchschen Paradoxons kommen, bei dem sich die Fehlerströme durch Kopplung auf der Sekundärseite 12b des Transformators 12 auf die gesunden Leiter der Primärseite 12a auswirken.

Das Auftreten des Bauchschen Paradoxons findet seine Erklärung in der Art der Verschaltung des Transformators 12 in Form der Stern-Dreieckverschaltung sowie der Einspeisung elektrischer Energie in die Energieversorgungsleitung 10 lediglich von dem Ende 11a der Energieversorgungsleitung 10, das dem Transformator 12 abgewandt ist. Durch seinen Aufbau ist der Transformator in der Lage, die sogenannte Nullsystemkomponente von Strömen und Spannungen zu übertragen. Für die Nullsystemgrößen bietet der konkrete Aufbau des Transformators 12 eine relativ kleine interne Nullsystemimpedanz, die sich überwiegend aus den Streuinduktivitäten der Transformatorwicklungen ergibt. Die Magnetisierungsinduktivität kann hier hingegen vernachlässigt werden, weil sie viel größer als die Streuinduktivität ist sowie in einer parallelen Schaltung zu den Streuinduktivitäten steht.

Wird der Transformator 12 unsymmetrisch und mit einer erkennbaren Nullsystemspannung betrieben, wie es im Falle eines ein- oder zweipoligen Erdkurzschlusses auf der Energieversorgungsleitung 10 vorkommt, so entsteht die Nullsystemkomponente im Strom, die in den Transformatorwicklungen fließt. Der Nullsystemstrom lässt sich nicht über die Sekundärseite 12b des Transformators 12 hinaus weiter übertragen, weil die sekundäre Dreieckschaltung bei dem Transformator 12 aufgrund der fehlenden Erdung keinen Abfluss der Nullsystemströme ermöglicht. Die Nullsystemkomponente in der Spannung bewirkt in den im Dreieck geschalteten Wicklungen der Sekundärseite 12b des Transformators 12 zirkulierende Ströme, die sich durch eine magnetische Kopplung der beiden Transformatorseiten auf die Primärseite 12a des Transformators 12 übertragen. Da diese zirkulierenden Ströme auf der Sekundärseite 12b die gleiche Phasenlage sowie die gleichen Amplituden besitzen, bewirken sie auch bei den Phasenströmen auf der Primärseite 12a des Transformators 12 analoge Verhältnisse, d.h. die Phasenströme auf der Primärseite 12a des Transformators 12 weisen eine übereinstimmende Phasenlage auf und haben die gleichen Amplituden.

In Figur 2 sind die Stromflussrichtungen in den einzelnen Phasenleitern 10a, 10b, 10c der Energieversorgungsleitung 10 und im Transformator 12 bei einem einpoligen Erdkurzschluss 20 zwischen dem Phasenleiter 10a und Erde 16 schematisch dargestellt. Zur Vereinfachung wurde für die Darstellung in Figur 2 angenommen, dass das Energieversorgungsnetz am Ende 11a der Energieversorgungsleitung 10, in das die elektrische Energie eingespeist wird, nicht geerdet ist. Der einpolige Erdkurzschluss 20 führt wegen der elektrisch unerwünschten Verbindung des Phasenleiters 10a mit Erde 16 dazu, dass eine fehlerbehaftete Phase-Erde-Schleife entsteht, in der der durch die Spannungsquelle der Einspeisung getriebene Kurzschlussstrom, dessen Fließrichtung in Figur 2 gestrichelt eingezeichnet ist, mit einer stark ausgeprägten Nullsystemkomponente fließt. Da die Spannungsquelle ohne Erdung arbeitet, kann der Kurzschlussstrom nur durch die Wicklungen des Transformators 12 fließen und durch die nicht fehlerbehafteten Phasenleiter 10b und 10c zur Energiequelle zurückkehren. Da die Wicklungen des Transformators 12 magnetisch miteinander gekoppelt sind, verursachen die auf der Primärseite 12a fließenden Ströme entsprechende Ströme auf der Sekundärseite 12b und umgekehrt. Der Nullsystemstrom zirkuliert in der Dreieck-Wicklung auf der Sekundärseite 12b des Transformators 12 und induziert entsprechende Ströme auf der Primärseite 12a des Transformators 12. Aus Figur 2 ist leicht zu erkennen, dass bei Betrachtung der signifikanten Phasenströme an der Messstelle 14b am der Einspeisung abgewandten Ende der Energieversorgungsleitung 10 in den eigentlich gesunden Phasenleitern 10b und 10c zwei fiktive, nicht kurzschlussbeteiligte Phase-Erde-Schleifen gebildet werden können, die sich aus der magnetischen Kopplung zwischen den Wicklungen des Transformators 12 ergeben. Diese fiktiven Schleifen dürfen nicht in die Berechnung der Schutzalgorithmen einbezogen werden.

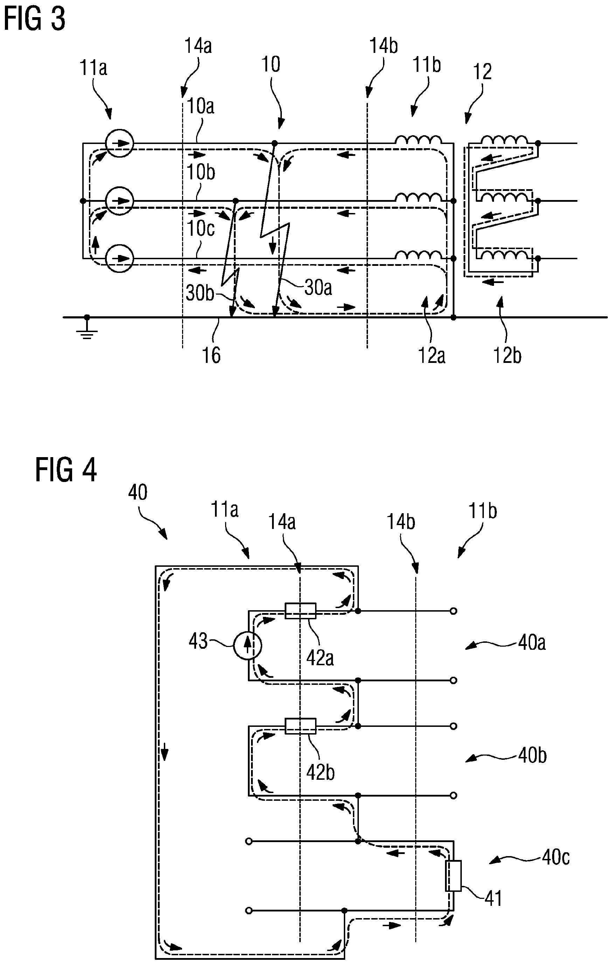

In Figur 3 sind die Stromflussrichtungen in der Energieversorgungsleitung 10 im Fall eines zweipoligen Erdkurzschlusses, der durch die ungewollten elektrischen Verbindungen 30a und 30b zwischen dem Phasenleiter 10a und Erde 16 sowie dem Phasenleiter 10b und Erde 16 gebildet ist, schematisch dargestellt. Analog zu dem in Figur 2 gezeigten einpoligen Erdkurzschluss entstehen auch hier in den Wicklungen auf der Sekundärseite 12b des Transformators 12 zirkulierende Ströme, die wiederum auf der Primärseite zueinander gleich großen Phasenströme in den Phasenleitern 10a, 10b, 10c verursachen. Dabei zeigt sich aus Sicht des Schutzgeräts an der Messstelle 14b eine "fiktive", nicht kurzschlussbeteiligte Phase-Erde-Schleife (zwischen dem Phasenleiter 10c und Erde 16), die sich aus der magnetischen Kopplung zwischen den Wicklungen des Transformators ergibt. Da es sich um den zweipoligen Fehler handelt, kann diese "fiktive" Schleife zum falschen Ansprechen des Schutzalgorithmus führen.

Aus der Betrachtung der Stromflüsse gemäß den Figuren 2 und 3 lässt sich der Rückschluss ziehen, dass die Auswertung der phasenleiterbezogenen Ströme zur korrekten Erkennung eines Erdkurzschlusses bei vorliegendem Bauchschen Paradoxon nicht ausreichend ist. Daher müssen die symmetrischen Komponenten herangezogen werden. Für die beiden Fehlerarten (einpoliger bzw. zweipoliger Erdkurzschluss) müssen hierfür zwei unterschiedliche Ersatzschaltbilder in Form von symmetrischen Komponenten erstellt werden.

In Figur 4 ist daher ein Ersatzschaltbild 40 mit gestrichelt eingezeichnetem Stromfluss während eines einpoligen internen Erdkurzschlusses dargestellt. Das komplette Ersatzschaltbild 40 wird aus drei seriell verbundenen Teilschaltbildern gebildet, die für jede symmetrische Komponente gesondert betrachtet werden können. Konkret umfasst das Ersatzschaltbild 40 ein das Mitsystem repräsentierendes Teilschaltbild 40a, ein das Gegensystem repräsentierendes Teilschaltbild 40b und ein das Nullsystem repräsentierendes Teilschaltbild 40c. Bei der Betrachtung wurde lediglich beispielhaft und nicht einschränkend angenommen, dass an dem einspeisenden Ende 11a der Energieversorgungsleitung keine Erdung vorhanden ist. Somit ist im Teilschaltbild 40c kein Nullsystemstrom an der an diesem Ende 11a liegenden Messstelle 14a zu erwarten. Hingegen fließen in den Teilschaltbildern 40a und 40b Mitsystemströme bzw. Gegensystemströme durch die Leitungsimpedanzen 42a bzw. 42b.

Die Spannungsquelle 43 ist nur im Teilschaltbild des Mitsystems enthalten.

Der Transformator in Stern-Dreieckschaltung ist an dem anderen Ende 11b der Energieversorgungsleitung angeschlossen. Die niedrige Nullsystemimpedanz 41 des Transformators verursacht die in dem Teilschaltbild 40c ersichtliche Kurzschließung der Schaltung für das Nullsystem. Das trägt dazu bei, dass der Nullsystemstrom durch die Nullsystemimpedanz 41 fließen kann. Da der Erdkurzschluss auf der Energieversorgungsleitung vorliegt, kann das Bauchsche Paradoxon nur an der Messstelle 14b erkannt werden.

Aus dem Ersatzschaltbild 40 ergibt sich, dass der fließende Strom an der Messstelle 14b weder eine Mitsystem- noch eine Gegensystemkomponente aufweist. Ist eine Last an dem Transformator angeschlossen, dann treten im Strom Mitsystem- und Gegensystemkomponenten auf, die jedoch deutlich kleiner sind als die Nullsystemkomponente, da eine Lastimpedanz der angeschlossenen Last wesentlich größer als die Nullsystemimpedanz des Transformators ist. Aus diesem Grund wird die Erkennung des Bauchschen Paradoxons basierend auf der Nullsystemkomponente durchgeführt.

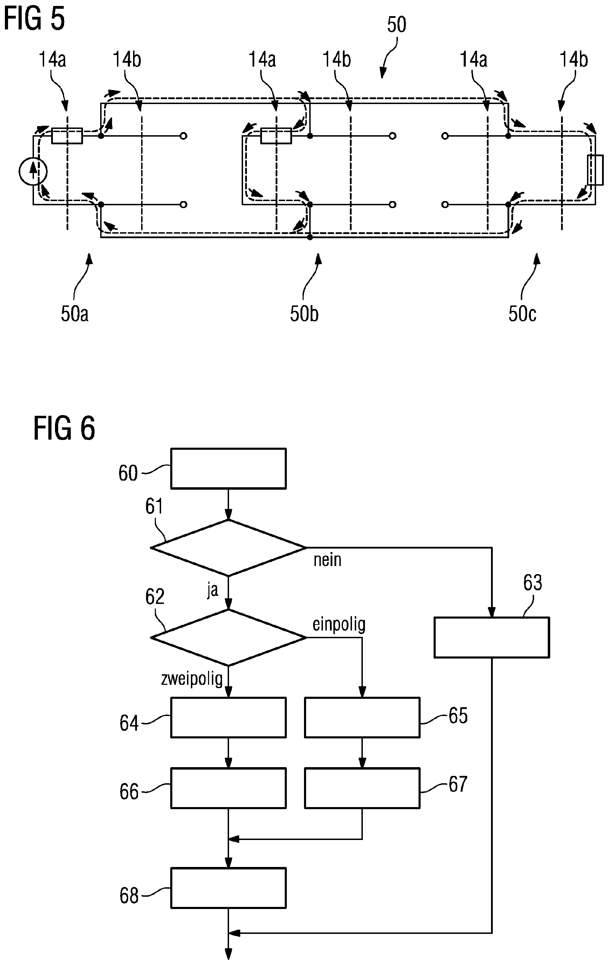

In Figur 5 ist ein Ersatzschaltbild 50 mit den Stromflüssen im Falle eines zweipoligen Erdkurzschlusses auf der Energieversorgungsleitung dargestellt. Das komplette Ersatzschaltbild 50 wird für diesen Fall aus drei parallel verbundenen Teilschaltbildern gebildet. Konkret umfasst das Ersatzschaltbild 50 ein das Mitsystem repräsentierendes Teilschaltbild 50a, ein das Gegensystem repräsentierendes Teilschaltbild 50b und ein das Nullsystem repräsentierendes Teilschaltbild 50c. Ähnlich wie bei dem einpoligen Erdkurzschluss gemäß Figur 4 sind im Falle eines zweipoligen Erdkurzschlusses keine - bzw. im Vergleich zur Nullsystemkomponente vernachlässigbare - Mit- und Gegensystemkomponenten des Stromes an der Messstelle 14b vorhanden. Dieser Effekt wird wiederum als Kriterium zur Erkennung des Bauchschen Paradoxons herangezogen.

Durch den Einsatz entsprechend angepasster Schutzalgorithmen zur Überwachung der Energieversorgungsleitung im Hinblick auf das Vorliegen eines Erdkurzschlusses ist es möglich, auch Erdkurzschlüsse, bei denen das Bauchsche Paradoxon auftritt, korrekt zu behandeln und selektiv abzuschalten. Hierzu findet ein mehrstufiger Prozess statt, der im Wesentlichen die Schritte "Erkennung des Vorliegens des Bauchschen Paradoxons", "Durchführung einer angepassten Schleifenauswahl" zur Erkennung der fehlerbehafteten Schleife und "Durchführung einer angepassten Richtungserkennung" zur Erkennung der Richtung, in der der Erdkurzschluss vom jeweiligen Schutzgerät aus gesehen liegt, umfasst. Eine Beschreibung des entsprechenden Schutzalgorithmus soll anhand des in Figur 6 dargestellten Ablaufdiagramms erfolgen. Dabei wird lediglich beispielhaft angenommen, dass es sich bei den den angepassten Schutzalgorithmus ausführenden Schutzgeräten 13a und 13b (vgl. Figur 1) um Distanzschutzgeräte handelt, die die Energieversorgungsleitung 10 normalerweise unter Verwendung eines üblichen Distanzschutzverfahrens auf Fehler überwachen. Zusätzlich zum Distanzschutzalgorithmus ist in den Schutzgeräten 13a, 13b der im Folgenden beschriebene angepasste Schutzalgorithmus implementiert, der lediglich dann wirksam wird, wenn das Bauchsche Paradoxon erkannt wird.

Der schematische Verlauf des angepassten Schutzalgorithmus ist in Figur 6 dargestellt. In einem ersten Schritt

werden hierbei von dem jeweiligen Schutzgerät die erforderlichen Messgrößen der einzelnen Phasenströme und Phasenspannungen an der Messstelle aufgenommen. Daraus werden im Zuge einer Messwertverarbeitung entsprechende Mitsystem-, Gegensystem- und Nullsystemgrößen berechnet.

In einem weiteren Schritt 61 wird anhand der aufgenommenen bzw. berechneten Messgrößen geprüft, ob der Effekt des Bauchschen Paradoxons vorliegt. Hierzu prüft das jeweilige Schutzgerät, ob die einzelnen Phasenströme und der Nullsystemstrom etwa gleich groß und in Phase sind und erzeugt ggf. ein Erdkurzschlussverdachtssignal. Beim Vergleich der Größen der Phasenströme und des Nullsystemstroms muss der Nullsystemstrom gemäß folgender Gleichung betrachtet werden:

$$\underline{I}_0 = \frac{\underline{I}_{L1} + \underline{I}_{L2} + \underline{I}_{L3}}{3} \, ,$$

wobei $\underline{I}_0$ eine Zeigergröße des Nullsystemstroms bezeichnet und $\underline{I}_{L1}$, $\underline{I}_{L2}$ und $\underline{I}_{L3}$ für die Zeigergrößen der einzelnen Phasenleiterströme stehen.

Da eine numerische Bestimmung der Phasenlage einzelner Messgrößen zueinander häufig sehr aufwendig ist, kann die Überprüfung der oben genannten Bedingung durch die Abfrage der folgenden beiden Kriterien ersetzt werden:

Gemäß dem ersten Kriterium wird der Nullsystemstrom mit dem Mitsystemstrom sowie dem Gegensystemstrom verglichen. Ist der Nullsystemstrom wesentlich größer als die beiden anderen symmetrischen Strom-Komponenten, so wird ein erstes Indikatorsignal erzeugt, das angibt, dass ein Bauchsches Paradoxon vorliegen könnte. Hierbei ist es ausreichend, wenn nur die Amplituden der symmetrischen Komponenten miteinander verglichen werden:

$$\left|\underline{I}_0\right| >> \left|\underline{I}_1\right| ,$$

$$\left|\underline{I}_0\right| >> \left|\underline{I}_2\right|$$

wobei $\underline{I}_0$, $\underline{I}_1$ und $\underline{I}_2$ entsprechend Zeigergrößen des Nullsystemstroms, des Mitsystemstroms und des Gegensystemstroms bezeichnen. Um die Methode robust gegenüber Messfehlern zu machen und dabei ein sicheres Ansprechen während des Bauchschen Paradoxons zu ermöglichen, sollte die Prüfung unter Verwendung eines Faktors k durchgeführt werden, der einen Wert wesentlich größer als 1 aufweist:

$$\left|\underline{I}_0\right| > k \cdot \left|\underline{I}_1\right| ,$$

$$\left|\underline{I}_0\right| > k \cdot \left|\underline{I}_2\right|$$

Gemäß dem zweiten Kriterium wird der Nullsystemstrom mit den einzelnen Phasenströmen verglichen, und es wird ein zweites Indikatorsignal erzeugt, wenn der Nullsystemstrom und die einzelnen Phasenströme etwa gleich groß sind. Der Vergleich kann auf Basis der Amplituden durchgeführt werden, weil die Prüfung der Phasenlage implizit bereits im ersten Kriterium enthalten ist. Hinsichtlich des zweiten Kriteriums werden daher folgende Bedingungen geprüft:

$$k_u \cdot \left|\underline{I}_{L1}\right| < \left|\underline{I}_0\right| < k_o \cdot \left|\underline{I}_{L1}\right| ,$$

$$k_u \cdot \left|\underline{I}_{L2}\right| < \left|\underline{I}_0\right| < k_o \cdot \left|\underline{I}_{L2}\right| ,$$

$$k_u \cdot \left|\underline{I}_{L3}\right| < \left|\underline{I}_0\right| < k_o \cdot \left|\underline{I}_{L3}\right|$$

wobei $k_u$ eine prozentuale untere Grenze und $k_o$ eine prozentuale obere Grenze für das Ansprechen des Kriteriums bezeichnen. Liegen sowohl das erste als auch das zweite Indikatorsignal vor, so wird das Erdkurzschlussverdachtssignal erzeugt.

Wird in Schritt 61 wie beschrieben das Vorliegen des Bauchschen Paradoxons erkannt und das Erdkurzschlussverdachtssignal erzeugt, so wird in Schritt 62 eine Erkennung der Fehlerart durchgeführt, das heißt, ob es sich um einen einpoligen oder einen zweipoligen Erdkurzschluss handelt. Andernfalls wird in Schritt 63 der "normale" Schutzalgorithmus betrieben, also beispielsweise ein Distanzschutzalgorithmus.

Die Festlegung der Fehlerart in Schritt 62 erfolgt durch einen Vergleich der Spannungen des Mitsystems und des Gegensystems. Ausgehend von dem Ersatzschaltbild für den zweipoligen Erdkurzschluss (vgl. Figur 5) lässt sich recht gut erkennen, dass für diese Fehlerart Gegensystemspannung und Mitsystemspannung in Bezug auf ihre Amplituden gleich sind. Da dies jedoch noch kein hinreichendes Kriterium ist, um die Fehlerart eindeutig zu erkennen, muss in dieser Prüfung auch die Phasenlage der beiden Komponenten zueinander analysiert werden. Die Differenz der Phasenlage kann für den zweipoligen Fehler, abhängig von der Referenzphase, theoretisch drei Werte besitzen: 0°, 120° oder 240°. Die Differenzbildung zwischen der Mitsystem- und Gegensystemspannung findet hierbei auf der Basis der Zeigergrößen statt, da aus den Amplitudenwerten eine Ableitung der Phasenwinkel nicht möglich ist. Hierbei wird jeweils eine der Komponenten rechnerisch um jeweils 120° und 240° gedreht, da die tatsächliche fehlerbehaftete Schleife unbekannt und somit nicht sicher ist, welche Phasenverschiebung zwischen der Mitsystem- und der Gegensystemspannung tatsächlich vorliegt. Aus dieser Berechnung entstehen folglich drei Differenzen, wobei nur eine der tatsächlichen Fehlerschleife entspricht. Beträgt eine der gebildeten Differenzen Null, so wird ein zweipoliger Fehler erkannt und ein einen zweipoligen Erdkurzschluss angebendes erstes Fehlerartsignal gebildet. Die hierzu geprüften - logisch mit ODER verbundenen - Bedingungen lauten:

$$\left|\underline{U}_1 - \underline{U}_2\right| \approx 0 \vee \left|\underline{U}_1 - e^{j120°} \cdot \underline{U}_2\right| \approx 0 \vee \left|\underline{U}_1 - e^{j240°} \cdot \underline{U}_2\right| \approx 0$$

wobei $\underline{U}_0$ eine Nullsystemspannung, $\underline{U}_1$ eine Mitsystemspannung und $\underline{U}_2$ eine Gegensystemspannung sind. Die exponentielle Komponente $e^{j120°}$ bzw. $e^{j240°}$ stellt die mathematische Drehung der Gegensystemspannung bezogen auf die Mitsystemspannung um den jeweiligen Phasenwinkel dar.

Da bei der Messung Fehler auftreten oder eine Lastübertragung im Energieversorgungsnetz stattfinden können, können die Zeigerdifferenzen zwischen der Mitsystem- und der Gegensystemspannung von dem idealen Wert Null leicht abweichen. Aus diesem Grund wird in der obigen Gleichung in der Praxis anstelle des Wertes Null ein Ansprechschwellenwert eingeführt, der eine Auswahl der richtigen Fehlerart trotz möglicher Abweichungen erlaubt. Der Ansprechschwellenwert ist dynamisch von der Größe der Gegensystemspannung und der Mitsystemspannung abhängig. Steigt eine dieser Komponenten an, so wird der Ansprechschwellenwert dynamisch erhöht:

$$S_A = m \cdot \max\left(\left|\underline{U}_1\right|, \left|\underline{U}_2\right|\right) + M$$

Dabei sind m ein vorgegebener prozentueller Abhängigkeitsfaktor und M eine konstante Schwelle. Durch die Verwendung des dynamisch bestimmten Ansprechschwellenwertes wird ein Ansprechen des Kriteriums sowohl bei niedrigen, als auch bei größeren Strömen ermöglicht. Erfüllt die Differenz zwischen dem Mitsystemstrom und dem Gegensystemstrom das auferlegte, dynamische Kriterium, so wird auf den zweipoligen Fehler geschlossen und das erste Fehlerartsignal erzeugt. Andernfalls wird ein einpoliger Fehler erkannt und ein einen einpoligen Fehler angebendes zweites Fehlerartsignal erzeugt.

Abhängig davon, welche Fehlerart detektiert wurde, wird die fehlerbehaftete Schleife auf unterschiedliche Weise detektiert. Wird durch das erste Fehlerartsignal ein zweipoliger Erdkurzschluss angezeigt, so werden in einem folgenden Schritt 64 die verketteten Spannungen (also die zwischen den jeweiligen Phasenleitern bestehenden Spannungen) untersucht und diejenigen beiden Phasenleiter als von dem zweipoligen Erdkurzschluss betroffen ausgewählt, deren gemeinsame verkettete Spannung die niedrigste ist. Die ausgewählte Fehlerschleife wird durch ein erstes Schleifenselektionssignal angezeigt. Wird hingegen durch das zweite Fehlerartsignal angezeigt, dass es sich um einen einpoligen Erdkurzschluss handelt, so werden in einem alternativen Schritt 65 die jeweiligen Phasenspannungen (also die Spannungen zwischen dem jeweiligen Phasenleiter und Erde) untersucht und derjenige Phasenleiter als von dem einpoligen Erdkurzschluss betroffen ausgewählt, der die niedrigste Phasenspannung aufweist. Die ausgewählte Fehlerschleife wird durch ein zweites Schleifenselektionssignal angezeigt.

In nun folgenden Schritten 66 bzw. 67 wird die Impedanz der durch das jeweiligen Schleifenselektionssignal ausgewählten Fehlerschleife auf ihre Lage in einem Anregegebiet untersucht, und es wird ein Bestätigungssignal erzeugt, wenn die Impedanz der Fehlerschleife innerhalb des Auslösegebietes liegt. Hierzu können die üblicherweise im Rahmen eines Distanzschutzalgorithmus eingesetzten Anregegebiete zur Beurteilung von Fehlerschleifenimpedanzen verwendet werden.

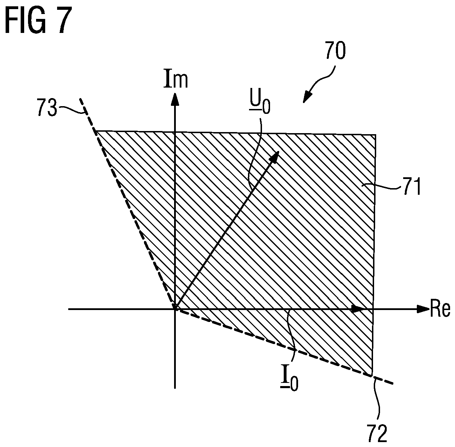

Nur dann, wenn das Bestätigungssignal erzeugt worden ist, also die Impedanz der ausgewählten Fehlerschleife im jeweiligen Anregegebiet liegt, wird in einem abschließenden Schritt 68 die Richtung untersucht, in der der Fehler von dem jeweiligen Schutzgerät aus gesehen liegt. Dabei bedeutet eine Vorwärtsrichtung die Erkennung eines Fehlers aus Richtung der überwachten Energieversorgungsleitung, während eine Rückwärtsrichtung auf einen externen Fehler außerhalb der überwachten Leitung schließen lässt. Die Richtungserkennung wird unabhängig von der erkannten Fehlerart (einpolig oder zweipolig) im Fall des Bauchschen Paradoxons nicht schleifenorientiert, sondern auf Basis der Nullsystemgrößen durchgeführt, da die phasenleiterbezogenen Messgrößen - wie zu den Abbildungen 4 und 5 erläutert, keine zuverlässigen Ergebnisse liefern würden. Zur Bestimmung der Fehlerrichtung werden die Zeigergrößen von Nullsystemstrom und Nullsystemspannung betrachtet. Aus den Erläuterungen zu Figuren 4 und 5 ist ersichtlich, dass sich die Nullsystemgrößen im Wesentlichen auf die Nullsystemimpedanz des Transformators zurückführen lassen. Da diese Impedanz induktiv ist, ist es zu erwarten, dass der Nullsystemstrom im Fall eines Vorwärtsfehlers (also eines auf der Leitung liegenden Erdkurzschlusses) der Nullsystemspannung nacheilt. Aus diesem Grund kann eine Richtungscharakteristik angewendet werden, wie sie beispielhaft in Figur 7 dargestellt ist.

Figur 7 zeigt hierzu ein Diagramm 70 in der komplexen Zahlenebene, in der Real- und Imaginärteil der Nullsystemkomponenten für Strom $\underline{I}_0$ und Spannung $\underline{U}_0$ dargestellt sind. Dabei wird der Zeiger für den Nullsystemstrom $\underline{I}_0$ auf der realen Achse abgebildet und als Referenzzeiger verwendet. Dazu muss er um 180° gedreht werden. Grundsätzlich ist zu erwarten, dass bei einem vorwärts gerichteten Erdkurzschluss beide Zeiger, d.h. sowohl für den um 180° gedrehten Nullsystemstrom, als auch für die Nullsystemspannung, im ersten Quadranten der komplexen Zahlenebene liegen. Um auch in diesem Fall Unsicherheiten aufgrund von Messungenauigkeiten auszugleichen, wird die Richtungscharakteristik durch die Grenzlinien 72 und 73 entsprechend erweitert. Beispielsweise können diese Grenzlinien bei -22° und +122° liegen.

Wird in Schritt 68 (vgl. Figur 7) ein Vorwärtsfehler erkannt, so wird ein Vorwärtssignal erzeugt, wodurch das Schutzgerät zur Abgabe eines Fehlersignals veranlasst wird, das an den entsprechenden Leistungsschalter 15a bzw. 15b (vgl. Figur 1) abgegeben wird. Bei Vorliegen des Fehlersignals öffnet der Leistungsschalter seine entsprechenden Schaltkontakte, um den jeweiligen fehlerbehafteten Phasenleiter vom übrigen Energieversorgungsnetz abzutrennen.

Durch den beschriebenen angepassten Schutzalgorithmus wird ein Schutzgerät, insbesondere ein Distanzschutzgerät in die Lage versetzt, auch bei Vorliegen des Effektes gemäß dem Bauchschen Paradoxon eine korrekte Erkennung und Abschaltung eines Erdkurzschlusses vorzunehmen. Bei Einsatz eines Distanzschutzgerätes kann die hohe Auslösegeschwindigkeit des Distanzschutzes voll ausgenutzt und alle Distanzschutzzonen (Anregegebiete) können verwendet werden. Zudem wird ein falsches Ansprechen des Distanzschutzes durch Verwendung des angepassten Schutzalgorithmus anstelle der üblichen Distanzschutzalgorithmen bei Vorliegen des Bauchschen Paradoxons vermieden. Der Transformator am Ende der Energieversorgungsleitung, der wie erläutert während des Fehlers beteiligt ist, kann effektiv gegen eine thermische Überlastung und Sättigung geschützt werden.

Der beschriebene angepasste Algorithmus lässt sich relativ einfach in Schutzgeräte, insbesondere Distanzschutzgeräte, jeder Art integrieren, weil alle zu verwendenden Messgrößen ohnehin zur Verfügung gestellt werden können.

## Patentansprüche

1. Verfahren zum Überwachen einer einseitig gespeisten Energieversorgungsleitung (10) eines dreiphasigen elektrischen Energieversorgungsnetzes im Hinblick auf das Vorliegen eines Erdkurzschlusses, wobei die Energieversorgungsleitung (10) an ihrem der Einspeisung abgewandten Ende (11b) mit einem in Stern-Dreieckschaltung betriebenen Transformator (12) verbunden ist,
   **dadurch gekennzeichnet, dass**

   - an einer Messstelle (14b), die an dem der Einspeisung abgewandten Ende (12b) der Energieversorgungsleitung (10) liegt, die Phasenströme in den einzelnen Phasenleitern (10a, 10b, 10c) der Energieversorgungsleitung (10) sowie der Nullsystemstrom ermittelt werden;
   - ein Erdkurzschlussverdachtssignal erzeugt wird, wenn die einzelnen Phasenströme und der Nullsystemstrom im Wesentlichen gleich groß und in Phase sind; und
   - das Erdkurzschlussverdachtssignal bei der weiteren Überwachung im Hinblick auf das Vorliegen des Erdkurzschlusses herangezogen wird, wobei zur Erkennung der Richtung, in der der Erdkurzschluss in Bezug auf die Messstelle (14b) liegt, der negative Nullsystemstromzeiger und der dazugehörende Nullsystemspannungszeiger verglichen werden und ein einen Erdkurzschluss in Vorwärtsrichtung angebendes Vorwärtssignal erzeugt wird, wenn der Nullsystemspannungszeiger dem negativen Nullsystemstromzeiger um einen Phasenwinkel mit einem vorgegebenen Differenzwert nacheilt.

2. Verfahren nach Anspruch 1,

**dadurch gekennzeichnet, dass**

- zur Überprüfung der Phasenlage der Phasenströme und des Nullsystemstroms auch der Mitsystemstrom und der Gegensystemstrom an der Messstelle (14b) ermittelt werden und der Nullsystemstrom einerseits mit dem Mitsystemstrom und andererseits mit dem Gegensystemstrom verglichen wird und ein erstes Indikatorsignal gebildet wird, wenn der Nullsystemstrom sowohl den Mitsystemstrom als auch den Gegensystemstrom um einen vorgegebenen Faktor übersteigt;
- der Nullsystemstrom auch mit den einzelnen Phasenströmen verglichen wird und ein zweites Indikatorsignal gebildet wird, wenn der Nullsystemstrom und die einzelnen Phasenströme nahezu gleich groß sind; und
- das Erdkurzschlussverdachtssignal erzeugt wird, wenn sowohl das erste Indikatorsignal als auch das zweite Indikatorsignal vorliegen.

3. Verfahren nach Anspruch 1 oder 2,
   **dadurch gekennzeichnet, dass**

   - bei vorliegendem Erdkurzschlussverdachtssignal zur Ermittlung der von dem Erdkurzschluss betroffenen Phasenleiter ein Vergleich der Zeiger für die Mitsystemspannung an der Messstelle (14b) und die Gegensystemspannung an der Messstelle (14b) durchgeführt wird, und ein auf einen zweipoligen Erdkurzschluss hindeutendes erstes Fehlerartsignal gebildet wird, wenn der von diesen Zeigern eingeschlossene Phasenwinkel etwa 0°, 120° oder 240° beträgt, und andernfalls ein zweites Fehlerartsignal gebildet wird, das auf einen einpoligen Erdkurzschluss hinweist.

4. Verfahren nach Anspruch 3,
   **dadurch gekennzeichnet, dass**

   - auch dann das erste Fehlerartsignal gebildet wird, wenn der von den Zeigern für die Mitsystemspannung und die Gegensystemspannung eingeschlossene Phasenwinkel um einen Ansprechschwellenwert von 0°, 120° oder 240° abweicht, wobei der Ansprechschwellenwert dynamisch von der Höhe der Mitsystemspannung und der Gegensystemspannung abhängt.

5. Verfahren nach Anspruch 3 oder 4,
   **dadurch gekennzeichnet, dass**

   - bei vorliegendem ersten Fehlerartsignal die verketteten Phasenspannungen der einzelnen Phasenleiter (10a, 10b, 10c) miteinander verglichen werden und ein erstes Schleifenselektionssignal gebildet wird, das diejenigen Phasenleiter(10a, 10b, 10c), die gemeinsam die niedrigste verkettete Phasenspannung bilden, als von einem zweipoligen Erdkurzschluss betroffen angibt; und
   - bei vorliegendem zweiten Fehlerartsignal die Phase-Erde-Spannungen der einzelnen Phasenleiter (10a, 10b, 10c) verglichen werden und ein zweites Schleifenselektionssignal gebildet wird, das denjenigen Phasenleiter (10a, 10b, 10c), der die niedrigste Phase-Erde-Spannung aufweist, als von einem einpoligen Erdkurzschluss betroffen angibt.

6. Verfahren nach einem der voranstehenden Ansprüche,
   **dadurch gekennzeichnet, dass**

   - bei vorliegendem Vorwärtssignal ein Fehlersignal erzeugt wird, dass ein Abschalten des von dem Erdkurzschluss jeweils betroffenen Phasenleiters (10a, 10b, 10c) bewirkt.

7. Verfahren nach Anspruch 6,
   **dadurch gekennzeichnet, dass**

   - für eine von dem Erdkurzschluss betroffene Phasenleiter-Erde-Schleife ein Impedanzzeiger bestimmt wird und die Lage des Impedanzzeigers in einem vorgegebenen Anregegebiet in der komplexen Zahlenebene untersucht wird,
   - ein Bestätigungssignal erzeugt wird, wenn der Impedanzzeiger in dem Anregegebiet liegt, und
   - das Fehlersignal zum Abschalten des von dem Erdkurzschluss betroffenen Phasenleiters (10a, 10b, 10c) nur dann erzeugt wird, wenn auch das Bestätigungssignal vorliegt.

**8.** Verfahren nach einem der vorangehenden Ansprüche,
**dadurch gekennzeichnet, dass**

- das Verfahren von einem Distanzschutzgerät (13a, 13b) ausgeführt wird, das eine Überwachung der Energieversorgungsleitung (10) unter Anwendung eines Fehlererkennungsalgorithmus nach Art eines Distanzschutzes durchführt, und bei Vorliegen des Erdkurzschlussverdachtssignals üblicherweise im Rahmen des von dem Distanzschutzgerät ausgeführten Fehlererkennungsalgorithmus durchgeführte Erkennungsalgorithmen zur Erkennung einer fehlerbehafteten Schleife und einer Fehlerrichtung blockiert werden.

**9.** Elektrisches Schutzgerät (13a, 13b) zur Überwachung einer einseitig gespeisten Energieversorgungsleitung (10) eines dreiphasigen elektrischen Energieversorgungsnetzes im Hinblick auf das Vorliegen eines Erdkurzschlusses, wobei die Energieversorgungsleitung (10) an ihrem der Einspeisung abgewandten Ende (11b) mit einem in Stern-Dreieckschaltung betriebenen Transformator (12) verbunden ist, mit

- einer Messeinrichtung zur Erfassung von Phasenströmen und Phasenspannungen an einer Messstelle (14b), die an dem der Einspeisung abgewandten Ende (11b) der Energieversorgungsleitung (10) liegt, und einer Datenverarbeitungseinrichtung, die zur Verarbeitung der Phasenströme und Phasenspannungen eingerichtet ist,
**dadurch gekennzeichnet, dass**
- die Datenverarbeitungseinrichtung zur Durchführung eines Verfahrens gemäß einem der Ansprüche 1 - 8 eingerichtet ist.

**Claims**

**1.** Method for monitoring a power supply line (10) of a three-phase electrical power supply network supplied at one end in respect of the presence of a short-to-ground, wherein the power supply line (10) is connected, at the end (11b) thereof remote from the supply, to a transformer (12) operated in a star-delta connection,
**characterised in that**

- the phase currents in the individual phase conductors (10a, 10b, 10c) of the power supply line (10) as well as the zero sequence current are determined at a measurement point (14b) lying at the end (12b) of the power supply line (10) remote from the supply;
- a suspected short-to-ground signal is generated if the individual phase currents and the zero sequence current are essentially of the same magnitude and are in phase; and
- the suspected short-to-ground signal is included in the further monitoring in respect of the presence of the short-to-ground, wherein, to detect the direction in which the short-to-ground lies in relation to the measuring point (14b), the negative zero sequence current pointer and the associated zero sequence voltage pointer are compared and a forwards signal specifying a short-to-ground in the forwards direction is generated if the zero sequence voltage pointer lags behind the negative zero sequence current pointer by a phase angle with a predetermined difference value.

**2.** Method according to claim 1,
**characterised in that**

- in order to check the phase angle of the phase currents and the zero sequence current the positive sequence current and the negative sequence current are also determined at the measuring point (14b) and the zero sequence current is compared on the one hand with the positive sequence current and on the other hand with the negative sequence current and a first indicator signal is formed if the zero sequence current exceeds both the positive sequence current and also the negative sequence current by a predetermined factor;
- the zero sequence current is also compared with the individual phase currents and a second indicator signal is formed if the zero sequence current and the individual phase currents are almost the same magnitude; and
- the suspected short-to-ground signal is generated if both the first indicator signal and also the second indicator signal are present.

**3.** Method according to claim 1 or 2,
**characterised in that**

- if the suspected short-to-ground signal is present, to determine the phase conductor affected by the short-to-ground, a comparison of the pointers for the positive sequence voltage at the measuring point (14b) and the negative sequence voltage at the measuring point (14b) is carried out, and an error type signal pointing to a two-pole short-to-ground is formed when the phase angle enclosed by these pointers amounts to around 0°, 120° or 240°, and otherwise a second error type signal is formed, which points to a single-pole short-to-ground.

4. Method according to claim 3,
**characterised in that**

- the first error type signal is also formed when the phase angle enclosed by the pointers for the positive sequence voltage and the negative sequence voltage deviates from a trigger threshold value of 0°, 120° or 240°, wherein the trigger threshold value depends dynamically on the level of the positive sequence voltage and the negative sequence voltage.

5. Method according to claim 3 or 4,
**characterised in that**

- if the first error type signal is present, the chained phase voltages of the individual phase conductors (10a, 10b, 10c) are compared to one another and a first loop selection signal is formed, which specifies those phase conductors (10a, 10b, 10c) which jointly form the lowest chained phase voltage as being affected by a two-pole short-to-ground; and
- if the second error type signal is present, the phase-ground voltages of the individual phase conductors (10a, 10b, 10c) are compared and a second loop selection signal is formed, which specifies those phase conductors (10a, 10b, 10c) which have the lowest phase-ground voltage as being affected by a single-pole short-to-ground.

6. Method according to one of the preceding claims,
**characterised in that**

- if the forwards signal is present, an error signal is generated which causes a switching off of the respective phase conductor (10a, 10b, 10c) affected by the short-to-ground.

7. Method according to claim 6,
**characterised in that**

- for a phase conductor-ground loop affected by the short-to-ground an impedance pointer is determined and the position of the impedance pointer in a predetermined excitation region is investigated in the complex number plane,
- a confirmation signal is generated if the impedance pointer lies in the excitation region, and
- the error signal for switching off the phase conductor (10a, 10b, 10c) affected by the short-to-ground is only generated if the confirmation signal is also present.

8. Method according to one of the preceding claims,
**characterised in that**

- the method is carried out by a distance protection device (13a, 13b) which monitors the power supply line (10) using an error detection algorithm as a kind of distance protection, and if the suspected short-to-ground signal is present, detection algorithms for detecting a loop affected by an error and an error direction, usually executed as part of the error detection algorithm executed by the distance protection device, are blocked.

9. Electrical protection device (13a, 13b) for monitoring a power supply line (10) of a three-phase electrical power supply network supplied at one end in respect of the presence of a short-to-ground, wherein the power supply line (10) is connected, at the end (11b) thereof remote from the supply, to a transformer (12) operated in a star-delta connection, with

- a measuring device for detection of phase currents and phase voltages at a measuring point (14b) which lies at the end (11b) of the power supply line (10) remote from the supply, and a data processing device, which is configured for processing the phase currents and phase voltages,
**characterised in that**

- the data processing device is configured for carrying out a method in accordance with one of claims 1 - 8.

**Revendications**

1. Procédé de contrôle d'une ligne (10) de distribution d'énergie alimentée unilatéralement en ce qui concerne la présence d'un court circuit à la terre, la ligne (10) de distribution d'énergie étant reliée, à une extrémité (11b) éloignée de l'alimentation, à un transformateur (12) fonctionnant dans un couplage étoile-triangle,
**caractérisé en ce que**

- on détermine en un point (14b) de mesure, qui se trouve à l'extrémité (12b) éloignée de l'alimentation de la ligne (10) de distribution d'énergie, les courants de phase dans les divers conducteurs (10a, 10b, 10c) de phase de la ligne (10) de distribution d'énergie ainsi que le courant de système homopolaire;
- on produit un signal de suspicion de court-circuit à la terre si les divers courants de phase et le courant de système homopolaire sont sensiblement de même intensité et en phase et
- on tire parti du signal de suspicion de court-circuit à la terre lors du contrôle ultérieur en ce qui concerne la présence du court-circuit à la terre, dans lequel, pour détecter le sens dans lequel se trouve le court-circuit à la terre par rapport au point (14b) de mesure, on compare le vecteur de courant négatif du système homopolaire et le vecteur de tension associé du système homopolaire et on produit un signal en avant indiquant un court-circuit à la terre dans le sens en avant si le vecteur de tension du système homopolaire suit, d'un angle de phase ayant une valeur de différence donnée à l'avance, le vecteur de courant négatif du système homopolaire.

2. Procédé suivant la revendication 1,
**caractérisé en ce que**

- pour contrôler la position en phase des courants de phase et du courant du système homopolaire, on détermine également le courant du système direct et le courant du système inverse au point (14b) de mesure et on compare le courant du système homopolaire d'une part au courant du système direct et d'autre part au courant du système inverse et on forme un premier signal d'indicateur, si le courant du système homopolaire dépasse tant le courant du système direct qu'également le courant du système inverse d'un facteur donné à l'avance;
- on compare le courant du système homopolaire également aux divers courants de phase et on forme un deuxième signal d'indicateur, si le courant du système homopolaire et les divers courants de phase sont à peu près de même intensité et
- on produit le signal de suspicion de court-circuit à la terre s'il y a à la fois le premier signal d'indicateur et le deuxième signal d'indicateur.

3. Procédé suivant la revendication 1 ou 2,
**caractérisé en ce que**

- en présence d'un signal de suspicion de court-circuit à la terre, on effectue, pour déterminer le conducteur de phase concerné par le court-circuit à la terre, une comparaison du vecteur de la tension du système direct au point (14b) de mesure et de la tension du système inverse au point (14b) de mesure et on forme un premier signal de type de défaut montrant un court-circuit à la terre bipolaire si l'angle de phase fait par ces vecteurs est d'environ 0°, 120° ou 240° et, sinon, on forme un deuxième signal de type de défaut, qui montre un court-circuit à la terre monopolaire.

4. Procédé suivant la revendication 3,
**caractérisé en ce que**

- on forme le premier signal de type de défaut même si l'angle de phase, fait par les vecteurs de la tension du système direct et de la tension du système inverse, s'écarte d'une valeur de seuil de réaction de 0°, 120° ou 240°, la valeur de seuil de réaction dépendant dynamiquement du niveau de la tension du système direct et de la tension du système inverse.

5. Procédé suivant la revendication 3 ou 4,
**caractérisé en ce qu'**

- en présence du premier signal de type de défaut, on compare entre elles les tensions de phase interconnectées des divers conducteurs (10a, 10b, 10c) de phase et on forme un premier signal d'élection de boucle, qui indique les conducteurs (10a, 10b, 10c) de phase, formant conjointement la tension de phase interconnectée la plus basse, comme concernés par un court-circuit à la terre bipolaire et

- en présence du deuxième signal de type de défaut, on compare les tensions phase-terre des divers conducteurs (10a, 10b, 10c) de phase et on forme un deuxième signal d'élection de boucle, qui indique le conducteur (10a, 10b, 10c) de phase ayant la tension phase-terre la plus basse, comme concerné par un court-circuit à la terre monopolaire.

**6.** Procédé suivant l'une des revendications précédentes,
**caractérisé en ce que**

- en présence d'un signal en avant, on produit un signal de défaut, qui provoque une mise hors circuit du conducteur (10a, 10b, 10c) de phase concerné par le court-circuit à la terre.

**7.** Procédé suivant la revendication 6,
**caractérisé en ce que**

- on détermine un vecteur d'impédance pour une boucle conducteur de phase-terre concernée par le court-circuit à la terre et on étudie la position du vecteur d'impédance dans un domaine d'excitation donné à l'avance dans le plan complexe,
- on produit un signal de confirmation si le vecteur d'impédance se trouve dans le domaine d'excitation et
- on ne produit le signal de défaut de mise hors circuit du conducteur (10a, 10b, 10c) de phase concerné par le court-circuit à la terre que s'il y a aussi le signal de confirmation.

**8.** Procédé suivant l'une des revendications précédentes,
**caractérisé en ce que**

- on réalise le procédé par un appareil (13a, 13b) de protection à distance, qui effectue un contrôle de la ligne (10) de distribution d'énergie en utilisant un algorithme de détection de défaut à la façon d'une protection à distance et, en présence du signal de suspicion de court-circuit à la terre, on bloque des algorithmes, effectués habituellement dans le cadre de l'algorithme de détection de défaut effectué par l'appareil de protection à distance, de détection d'une boucle défectueuse et d'un sens du défaut.

**9.** Appareil (13a, 13b) de protection électrique pour contrôler une ligne (10) de distribution d'énergie alimentée unilatéralement, d'un réseau de distribution d'énergie électrique triphasé, en ce qui concerne la présence d'un court-circuit à la terre, la ligne (10) de distribution d'énergie étant reliée à son extrémité (11b) éloignée de l'alimentation à un transformateur (12) fonctionnant suivant un couplage étoile-triangle, comprenant

- un dispositif de mesure pour détecter des courants de phase et des tensions de phase en un point (14b) de mesure, qui se trouve à l'extrémité (11b) éloigné de l'alimentation de la ligne (10) de distribution d'énergie et un dispositif de traitement de données, qui est conçu pour traiter les courants de phase et les tensions de phase,
**caractérisé en ce que**
- le dispositif de traitement de données est conçu pour effectuer un procédé suivant l'une des revendications 1 à 8.

FIG 1

FIG 2

FIG 3

FIG 4

FIG 5

FIG 6

# FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 881821